**Europäisches Patentamt**

**European Patent Office**

**Office européen des brevets**

(19)

(11) Veröffentlichungsnummer: **0 016 210**
**B1**

(12) # EUROPÄISCHE PATENTSCHRIFT

(45) Veröffentlichungstag der Patentschrift:
**12.01.83**

(21) Anmeldenummer: **79901086.3**

(22) Anmeldetag: **16.08.79**

(86) Internationale Anmeldenummer:
**PCT/DE 79/00086**

(87) Internationale Veröffentlichungsnummer:
**WO 80/00495 (20.03.80** Gazette **80/6)**

(51) Int. Cl.³: **G 01 R 1/04,** G 01 D 11/24

(54) **TRAGBARES VIELFACHMESSGERÄT IN KLAPPPAUSFÜHRUNG.**

(30) Priorität: **22.08.78 DE 2836679**

(43) Veröffentlichungstag der Anmeldung:
**01.10.80 Patentblatt 80/20**

(45) Bekanntmachung des Hinweises auf die Patenterteilung:
**12.01.83 Patentblatt 83/2**

(84) Benannte Vertragsstaaten:
**FR**

(56) Entgegenhaltungen:

**DE-A-2 502 583**
**Electronics, volume 48, no. 7, veröffentlicht am**
**3. April 1975 (New York, USA)**
**Electronics review «Compact diary, checkbook all**
**count», siehe Seite 40, mittlere Spalte, 3. Absatz**
**und Seite 40, Abbildung links unten**

(73) Patentinhaber: **METRAWATT GMBH NÜRNBERG,**
**Thomas-Mann-Strasse 20, D-8500 Nürnberg (DE)**

(72) Erfinder: **HEINZE, Siegfried, Neidsteiner Strasse 6,**
**D-8500 Nürnberg (DE)**
Erfinder: **HOCHREUTHER, Karl, Hersbrucker Strasse 98,**
**D-8500 Nürnberg (DE)**
Erfinder: **SCHOLPP, Werner, St. Georgen, A-5662 Gries**
**(AT)**

(74) Vertreter: **Kempe, Wolfgang, Dr., c/o Brown, Boveri &**
**Cie AG Postfach 351, D-6800 Mannheim 1 (DE)**

## Tragbares Vielfachmessgerät in Klappausführung

Die Erfindung bezieht sich auf ein tragbares Vielfachmessgerät, bei dem sowohl die zur Sichtbarmachung des Messwertes einer zu untersuchenden Messgrösse dienende Anzeigebaugruppe wie auch die die Messgrösse umformende bzw. anpassende Verarbeitungsbaugruppe ein eigenes Gehäuse besitzen und beide Gehäuse so miteinander verbunden sind, dass sie im Ruhezustand zusammenklappbar sind, wobei zu schützende Bedien- und Anzeigeteile nach innen zu liegen kommen.

Lässt man die elektrischen Eigenschaften eines Vielfachmessgerätes ausser Betracht, so legt der Anwender besonderen Wert auf gute Ablesbarkeit, bequeme Handhabung und Robustheit.

Die gute Ablesbarkeit setzt eine grosse Anzeigefläche zur Darstellung des Messwertes voraus. Dabei sollte die Anzeigefläche gleichzeitig so angeordnet sein, dass der Betrachter ohne Verrenkungen eine nahezu senkrechte Blickrichtung hierzu einnehmen kann.

Die bequeme Handhabung bedingt zunächst einmal, dass es sich um ein leichtes und handliches Messgerät handelt, das ohne Umstände an verschiedene Arbeitsplätze mitgenommen werden kann. Weiterhin müssen die einzelnen Bedienelemente gut zugänglich sein.

Robustheit ist von einem Vielfachmessgerät schon deshalb zu fordern, weil es häufig transportiert werden muss. Dabei dürfen empfindliche Teile, z. B. solche aus Glas, nicht zerbrechen und die Anzeige- und Bedienelemente nicht verschmutzen.

Es ist leicht zu erkennen, dass nicht alle genannten Forderungen ohne weiteres erfüllbar sind, da sie zum Teil divergierende Massnahmen voraussetzen. So ist bei einem kleinen handlischen Messgerät nur schwer eine grosse Anzeigefläche zu realisieren. Auch die Forderung nach Robustheit gegenüber mechanischer Beanspruchung beim Transport kann nur durch Massnahmen erfüllt werden, die zu einer Vergrösserung des Messgerätes führen. Das gilt sowohl für den Einsatz von Schutztaschen, die zudem fast immer hinderlich sind, wie auch für die Anwendung eines Deckels, der über die zu schützenden Elemente geklappt werden kann.

Es erscheint zunächst naheliegend, ein Vielfachmessgerät ähnlich wie das in der DE-A-2 636 079 beschriebene Leitungssuchgerät so aufzubauen, dass Teile des Messgerätes in einer deckelartigen nach aussen schwenkbaren Klappe untergebracht sind. Aus der DE-A-2 458 766 ist weiterhin bekannt, ein Messgerät mechanisch derart aufzuteilen, dass eine Anzeigebaugruppe mit Messwerk und Skalenscheibe sowie eine Verarbeitungsbaugruppe mit Messbereichswahlschalter und Verstärker entstehen.

Ein klappbares Vielfachmessgerät, bei dem die Anzeigebaugruppe im Deckel untergebracht ist, hätte erhebliche Vorteile gegenüber konventionell aufgebauten Geräten. Zum Transport könnte ein derartiges Gerät einfach zusammengeklappt werden, so dass die innenliegenden Bedien- und Anzeigeelemente durch die äusseren Gehäuseteile geschützt wären. Als weiterer Vorteil käme hinzu, dass beim Aufklappen des Gerätes die Bedien- und Anzeigefläche zusammen doppelt so gross sind, wie seine Grundfläche. Die sich zunächst entgegenstehenden Forderungen nach grosser Anzeigefläche und Robustheit einerseits und Handlichkeit andererseits lassen sich also auf diese Weise weitgehend erfüllen. Es sei hier darauf hingewiesen, dass ein kleiner elektronischer Rechner mit einer Tastatur im Gehäuse und der Anzeige im Deckel an sich bekannt ist aus der DE-A-25 02 583.

Obwohl der Gedanke, ein klappbares Vielfachmessgerät zu konstruieren, naheliegend sein mag, bringt die praktische Gestaltung eines wirklich handlichen und zweckmässigen Gerätes erhebliche Probleme, die zu lösen Aufgabe der Erfindung ist. Im Besonderen ist es Aufgabe der Erfindung, ein tragbares Vielfachmessgerät zu schaffen, das eine flache Bauform mit abgerundeten Aussenkanten besitzt, damit das zusammengeklappte Gerät notfalls auch in eine Hosentasche gesteckt werden kann. Das Messgerätegehäuse ist dabei so zu gestalten, dass bei geringen äusseren Abmessungen der Innenraum gut zu nutzen ist und sich gleichzeitig günstige Verhältnisse für das Ablesen und Bedienen des Messgerätes ergeben.

Diese Aufgabe wird dadurch gelöst, dass die Gehäuse im Bereich der Kante, um welche beim Zusammenklappen eine Schwenkung erfolgt, einen den nutzbaren Innenraum der Gehäuse erweiternden, vorzugsweise zylindrischen Wulst besitzen, der gleichzeitig als Scharnier ausgebildet ist, derart, dass zu jedem Gehäuse mindestens ein Scharnierglied gehört und die Gehäuse durch die den Wulst bildenden, ineinandergreifenden Scharnierglieder drehbar verbunden sind.

Vorzugsweise besitzen die Gehäuse abgesehen vom Wulst eine im wesentlichen quaderförmige Grundform, und der Wulst schliesst mit den aussenliegenden Gehäuseflächen, der Standfläche und der Deckfläche, in einer Ebene ab. Dadurch ergibt sich ein kompaktes Gerät mit einem gefälligen Äusseren.

Vorteilhafterweise ragt der Wulst über die Ebene mindestens einer der innen liegenden Flächen, d. h. über die Bedienfläche bzw. die Anzeigefläche, hinaus und der Aussendurchmesser des Wulstes entspricht etwa der Gesamthöhe der beiden zusammengeklappten Gehäuse.

Gemäss einer vorteilhaften Weiterbildung ist der zylindrische Wulst als dreigliedriges Scharnier ausgeführt und bei dem mittleren Scharnierglied, das zum Gehäuse der Anzeigebaugruppe gehört, sind beidseitig Lagerringe abgesetzt, die von den beiden äusseren Scharniergliedern, die zum Gehäuse der Verarbeitungsbaugruppe gehören, überlappt sind. Durch diese Konstruktion ergibt sich eine besonders stabile Verbindung der beiden Gehäuse.

Vorzugsweise erhebt sich der zylindrische Wulst mit weniger als der Hälfte seines Aussendurchmessers über die Bedienfläche und das Gehäuse der Verarbeitungsbaugruppe ist aus zwei Gehäuseschalen zusammengesetzt, wobei die zwischen ihnen liegende Trennfläche parallel zur Bedienfläche verläuft und die zum Gehäuse der Verarbeitungsbaugruppe gehörigen Teile des zylindrischen Wulstes halbiert. Auf diese Weise wird die Montage des Scharniers besonders vereinfacht.

Vorteilhafterweise liegt die Anzeigefläche im zusammengeklappten Zustand des Messgerätes plan auf der Bedienfläche nur durch ein flaches Pufferelement getrennt auf und Bedienelemente wie der Knopf des Messbereichswahlschalters liegen in Vertiefungen der Bedienfläche. Hierdurch ergibt sich im zusammengeklappten Zustand ein besonders kompaktes Gerät. Das gesonderte Pufferelement verhindert ein hartes Aufeinanderschlagen der beiden Gehäuse.

Vorzugsweise erlauben die ineinandergelagerten Scharnierglieder des zylindrischen Wulstes eine Drehschwenkung bis zu maximal 180°; dabei üben sie aufeinander eine solche Friktion aus bzw. sind so mt Rastnasen versehen, dass beide Gehäuseteile jede Winkelstellung entgegen der Schwerkraft beibehalten. Hierdurch wird die Brauchbarkeit des Messgerätes stark erhöht, da der Benutzer die Anzeigebaugruppe gegenüber der Verarbeitungsbaugruppe so einstellen kann, dass sein Blick optimal auf die Anzeige fällt.

Gemäss einer vorteilhaften Weiterbildung ist das mittlere Scharnierglied des zylindrische Wulstes derart gegenüber der Mitte des Gehäuses versetzt, dass die beiden äusseren Scharnierglieder unterschiedlich lang sind und damit ein unterschiedliches Fassungsvermögen besitzen. Eine derartige Anordnung ist dann von Vorteil, wenn der Innenraum mindestens eines der beiden äusseren Scharnierglieder zur Aufnahme handelsüblicher Batterien ausgerüstet und durch einen abnehmbaren Deckel nach aussen verschlossen ist. Das Innere des Wulstes eignet sich wegen seiner zylindrischen Form besonders gut zur Aufnahme von zylindrischen Batterien, die als Stromversorgung für die Elektronik in der Verarbeitungsbaugruppe dienen.

Nach einer vorteilhaften Weiterbildung der Erfindung dient der Innenraum des zur Anzeigebaugruppe gehörigen Scharniergliedes zur Aufnahme eines Messwerktubus eines elektromechanischen Messwerkes, das einschliesslich Skala und Messzeiger im Gehäuse der Anzeigebaugruppe untergebracht ist, wobei das Messwerk so aufgebaut ist, dass der grösste Teil des Messwerktubus die Ebene der Skalenvorderseite überragt. Diese besondere Konstruktion ermöglicht es, die Anzeigebaugruppe besonders flach zu bauen, da der grösste Teil des Messwerktubus in dem die Anzeigefläche überragenden Teil des Wulstes liegt.

Vorzugsweise sind auf der dem zylindrischen Wulst gegenüberliegenden Seite an beiden Ekken des zur Verarbeitungsbaugruppe gehörigen Gehäuses Aussparungen mit je einem eingesetzten Stift vorgesehen, an denen ein Trageband zu befestigen ist. Mit Hilfe dieses Tragebandes kann der Benutzer das Messgerät während der Messung um den Hals hängen. Durch geeignetes Abwinkeln der Anzeigebaugruppe gegenüber der Verarbeitungsbaugruppe wird ein optimaler Blick des Benutzers auf die Anzeige ermöglicht.

Vorzugsweise ist auf der Bedienebene ein Druckschalter angebracht, der beim Zusammenklappen der beiden Gehäuseteile vom Anzeigeteil erfasst wird und dadurch das Messgerät abschaltet; ausserdem ist dieser Druckschalter durch Drehen oder Schieben zusätzlich in eine solche Raststellung zu bringen, in der das Messgerät auch bei aufgeklapptem Gehäuse abgeschaltet werden kann. Auf diese Weise wird bei zusammengeklapptem Gehäuse ein unbemerktes Leerlaufen der Batterien verhindert.

Gemäss einer Weiterbildung der Erfindung deckt die Anzeigebaugruppe die Bedienfläche im zusammengeklappten Zustand des Messgerätes nur zum Teil ab und einzelne, auf der Bedienfläche angeordnete Bedienelemente, z. B. die Anschlussbuchsen, bleiben auch beim teilweise oder ganz zusammengeklappten Vielfachmessgerät zugänglich.

Die mit der Erfindung erzielten Vorteile bestehen insbesondere darin, dass durch die Ausbildung eines zylindrischen Wulstes mit relativ grossem Durchmesser als Scharnier einerseits eine Drehschwenkung der beiden Gehäuse zueinander ermöglicht wird und andererseits innerhalb des zylindrischen Wulstes relativ viel Raum für Bauelemente des Messgerätes verbleibt. Die grossen Scharnierglieder machen es leicht, zwischen ihren Berührungsflächen eine Friktion solcher Art zu schaffen, dass die Anzeigebaugruppe in nahezu jede gewünschte Winkelstellung zur Verarbeitungsbaugruppe gebracht werden kann, ohne dass die Schwerkraft ein Kippen aus dieser Stellung bewirkt. Die Rundung des zylindrischen Wulstes kommt im übrigen der Forderung nach abgerundeten Kanten entgegen.

Ein Ausführungsbeispiel der Erfindung ist in der Zeichnung dargestellt und wird im folgenden näher beschrieben. Es zeigen:

Fig. 1 das mit einem Öffnungswinkel von 180° aufgeklappte Vielfachmessgerät in Draufsicht, also mit Blick auf Anzeige- und Bedienebene. (Um die Details der Scharnierglieder besser sichtbar zu machen, sind die beiden Baugruppen getrennt dargestellt. Fig. 1A zeigt die Anzeigebaugruppe und Fig. 1B die Verarbeitungsbaugruppe);

Fig. 2 das zusammengeklappte, auf seiner Grundfläche stehende Vielfachmessgerät von vorne gesehen;

Fig. 3 das zusammengeklappte Vielfachmessgerät von der Seite gesehen mit Blick auf die Anschlussbuchsen;

Fig. 4 das zusammengeklappte Vielfachmessgerät von oben gesehen,

Fig. 5 das zusammengeklappte Vielfachmessgerät von hinten (in Rückenlage) gesehen;

Fig. 6 eine Anzeigebaugruppe mit Messwerk im Schnitt dargestellt, wobei der Schnitt entlang der Messwerkmittellinie verläuft;

Fig. 7 eine Verarbeitungsbaugruppe im Schnitt dargestellt, wobei der Schnitt in derselben Ebene liegt, wie bei der Anzeigebaugruppe.

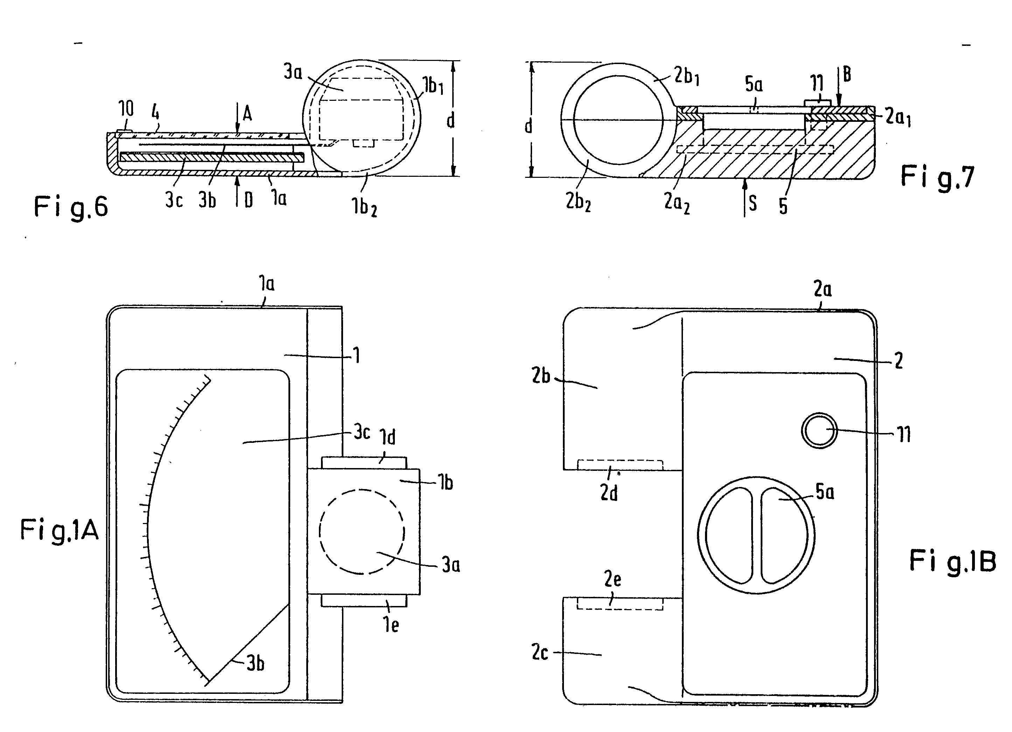

Wie die Fig. 1A und 1B zeigen, besteht das Vielfachmessgerät aus einer Anzeigebaugruppe 1 und einer Verarbeitungsbaugruppe 2. In dem Gehäuse 1a der Anzeigebaugruppe 1 sind besonders solche Bauelemente untergebracht, die dazu dienen sollen, den Messwert einer Messgrösse sichtbar zu machen. Bei dem vorliegenden Beispiel erfolgt die Messwertanzeige mit Hilfe eines elektromechanischen Messwerks 3, dessen Messwerktubus 3a, Messzeiger 3b und Skalenscheibe 3c in Fig. 1A dargestellt sind. Das Gehäuse 1a ist jedoch so konzipiert, dass an die Stelle des Messwerkes 3 ebenso gut eine digitale Anzeige, z. B. aus Leuchtdioden oder Flüssigkristallen, treten kann. Die Anzeigeelemente sind durch eine Klarsichtscheibe 4 geschützt.

Da die Messgrösse, besonders bei einem Vielfachmessgerät, selten mit einem Wert vorliegt, der unmittelbar der Anzeigebaugruppe 1 zugeführt werden kann, muss zunächst eine geeignete Umformung oder Anpassung erfolgen. Die hierzu benötigten Bauelemente wie Messbereichsschalter, Verstärker usw., sind in der in Fig. 1B dargestellten Verarbeitungsbaugruppe 2 zusammengefasst.

Soweit Platz ist, können Bauelemente, die an sich der Verarbeitungsbaugruppe 2 zuzuordnen wären, auch im Gehäuse der Anzeigebaugruppe 1 untergebracht sein, bzw. umgekehrt.

Für die Trennung gilt das Gesetz der Zweckmässigkeit, es muss lediglich das Ziel der Erfindung, die Anzeigefläche eines Vielfachmessgerätes zu vergrössern, indem die Bedienelemente auf einer zusätzlichen Fläche angeordnet sind, erreicht werden.

Die in Fig. 1A mit Blick auf die Anzeigeebene A dargestellte Anzeigebaugruppe 1 ist in Fig. 6 von der Seite gesehen im Schnitt dargestellt, wobei der Schnitt entlang der Mittellinie des Messwerkes 3 verläuft. In gleicher Beziehung zueinander stehen Fig. 1B und Fig. 7. Aus den Darstellungen ist erkennbar, dass die Gehäuse 1a, 2a der beiden Baugruppen 1, 2, von Rundungen an den Aussenkanten abgesehen, eine im wesentlichen quaderförmige Grundform besitzen.

Diese Grundform wird jedoch im Bereich der Kante, um die eine Drehschwenkung zwischen den beiden Gehäusen 1a, 2a erfolgen soll, verlassen. Im Bereich dieser Kante ist bei beiden Gehäusen ein zylindrischer Wulst 1b, 2b, 2c ausgebildet, der den nutzbaren Innenraum der beiden Gehäuse wesentlich erhöht und ausserdem als Scharnier wirkt.

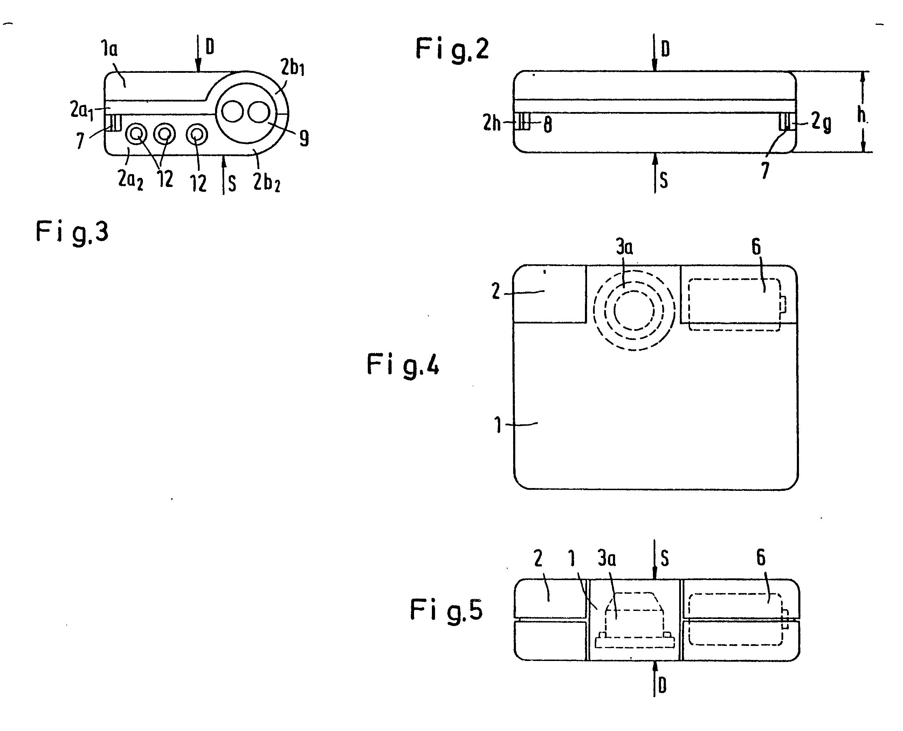

Obwohl der zylindrische Wulst 1b, 2b, 2c ein fest integrierter Bestandteil der Gehäuse 1a, 2a ist, wurde er zur deutlicheren Kennzeichnung mit eigenen Kennziffern versehen. Im übrigen ist dieser Wulst so ausgebildet, dass er nach dem Zusammenklappen der beiden Gehäuse praktisch nicht in Erscheinung tritt (Fig. 3 bis 5). Das bedeutet, dass sein äusserer Durchmesser der Gesamthöhe der beiden zusammengeklappten Gehäuse entspricht und seine Mantelfläche in die aussen liegende Standfläche S, sowie die Deckfläche D, stetig übergeht, ohne sich über diese zu erheben. Dagegen ragt der zylindrische Wulst über die innen liegende Bedienfläche B und die Anzeigefläche A wesentlich hinaus.

Bei dem vorliegenden Beispiel ist der zylindrische Wulst in drei Scharnierglieder 1b, 2b, 2c unterteilt. Dabei ist das zum Gehäuse 1a der Anzeigebaugruppe 1 gehörende Scharnierglied 1b zwischen zwei zum Gehäuse 2a der Verarbeitungsbaugruppe 2 gehörenden Scharniergliedern 2b, 2c gelagert. Die hier gewählte Dreiteilung des zylindrischen Wulstes ist jedoch nicht zwangsläufig; ebenso wie eine Aufteilung in mehr als drei Scharnierglieder möglich ist, könnten auch nur zwei Scharnierglieder gewählt werden. In diesem Fall müssten Teile der Zylinderflächen sich einseitig überlappend ineinandergreifen und miteinander verankert sein.

Die in der Zeichnung dargestellte Lösung sieht für das mittlere, zur Anzeigebaugruppe 1 genörende Scharnierglied 1b, eine zweiseitige Lagerung vor. Hierzu ist der zylindrische Körper des Scharniergliedes 1b beidseitig so weit abgesetzt, dass zwei Lagerringe 1d, 1e entstehen. Die Lagerringe passen in entsprechende Aussparungen 2d, 2e der Scharnierglieder 2b, 2c.

Die Scharnierglieder sind so ausgeführt, dass die beiden Gehäuse 1a, 2a eine Drehschwenkung von 0 bis 180° zueinander erlauben. Damit die Gehäuse innerhalb dieses Drehbereiches in eine beliebige, für den Betrachter optimale Stellung gebracht werden können und sie diese Stellung entgegen der Schwerkraft auch beibehalten, ist für eine geeignete Friktion zwischen den Lagerflächen gesorgt. Die Friktion kann entweder durch eine entsprechende Passung oder durch Rastnoppen erfolgen, die zwischen den Lagerflächen ausgebildet sind.

Die Montage der Scharnierglieder 1b, 2b, 2c und damit der Gehäuse 1a, 2a wird durch einen besonderen Aufbau des Gehäuses 2a ermöglicht. Dieses besteht aus zwei Gehäuseschalen 2a₁, 2b₁; 2a₂, 2b₂, deren Trennungsebene parallel zur Bedienfläche B liegt und den zylindrischen Wulst 2b halbiert. Nimmt man die obere Gehäuseschale 2a₁, 2b₁ ab, so kann das Scharnierglied 1b der Anzeigebaugruppe 1 frei eingesetzt werden. Die zum Verbinden der oberen Gehäuseschale 2a₁, 2b₁ mit der unteren Gehäuseschale 2a₂, 2b₂ benötigten Teile sind nicht näher dargestellt, da diese in bekannter Weise als Schraub- bzw. Klemmelemente ausgeführt sind.

Die Bedienelemente, so z. B. der Knopf 5a zur Betätigung des Messbereichsschalters 5, sind so in die obere Gehäuseschale 2a₁, 2b₁ eingelassen, dass sie nicht über die Bedienfläche B hinausragen. Beim Zusammenklappen der beiden Baugruppen liegen somit die Anzeigefläche A und die Bedienfläche B plan aufeinander. Auf einer der beiden Flächen ist allerdings ein Pufferelement 10 angeordnet, das ein hartes Aufeinanderschlagen der beiden Baugruppen verhindert.

Von wesentlicher Bedeutung ist die gute Nutzbarkeit des Innenraumes der Scharnierglieder. Ihre zylindrische Form ist besonders für die Aufnahme einer Batterie 6, z. B. einer handelsüblichen Monozelle, geeignet. Das Auswechseln der Batterie 6 wird durch einen abnehmbaren Deckel 9 ermöglicht, der das jeweilige Scharnierglied an seiner äusseren Stirnseite abschliesst. Die Scharnierglieder 2b, 2c sind im übrigen unterschiedlich lang gestaltet, um ihren Innenraum den jeweiligen Forderungen optimal anzupassen. Das mittlere zur Anzeigebaugruppe 1 gehörige Scharnierglied 1b ist dementsprechend gegenüber der Gehäusemitte versetzt.

Konstruktive Ideen besonderer Art waren in Verbindung mit dem Einbau des elektromechanischen Messwerks 3 erforderlich.

Das Ziel, ein möglichst flaches Mesgerät zu bauen, ist nur zu realisieren, wenn der Messwerktubus 3a nicht die Höhe der gesamten Anzeigebaugruppe 1 bestimmt. Einer Lösung, den Messwerktubus 3a im Scharnierglied 1b der Anzeigebaugruppe 1 unterzubringen, stand zunächst entgegen, dass sich der Innenraum des Scharniergliedes im wesentlichen oberhalb der Anzeigefläche A und damit auch der Skalenscheibe 3c befindet, während der Messwerktubus 3a bei üblichen Messwerken im wesentlichen unterhalb der Skalenscheibe, im Bereich ihrer Rückseite angeordnet ist.

Wie Fig. 6 erkennen lässt, ist das in die Anzeigebaugruppe 1 eingesetzte Messwerk 3 so aufgebaut, dass der Messwerktubus 3a in das Scharnierglied 1b hineinragt. Die Höhe des Gehäuses 1a wird somit im wesentlichen durch Skalenscheibe 3c und Messzeiger 3b bestimmt. Das Scharnierglied 1b besteht aus zwei Gehäuseteilen 1b₁, 1b₂, die zum Einsetzen des Messwerkes 3 getrennt werden. Auch hier sind die zum Zusammenfügen der Gehäuseteile 1b₁, 1b₂ erforderlichen Verbindungselemente nicht näher dargestellt, da bekannte Techniken zur Anwendung kommen.

Von besonderem Vorteil für den Anwender ist es, dass die Anzeigebaugruppe 1 in eine beliebige Winkelstellung zur Verarbeitungsbaugruppe 2 gebracht werden kann. Denn hierdurch wird es nicht nur möglich, das Gerät auf jedem Arbeitstisch in eine optimale Stellung zu bringen, sondern es auch an einem Tragband während der Messung um den Hals zu hängen. Die Befestigung des Tragbandes kann an zwei Stiften 7, 8 erfolgen, die an den Ecken im Bereich der dem zylindrischen Wulst gegenüberliegenden Vorderseite der Verarbeitungsbaugruppe 2 in Aussparungen 2g, 2h eingesetzt sind. Das um den Hals gehängte Messgerät liegt mit seiner Standfläche S am Körper an und ermöglicht bei einem um ca. 90° abgewinkelten Anzeigeteil 1 eine bequeme Ablesung. Der Messtechniker hat damit die Hände für seine Arbeit frei.

Die Bedienung des Messgerätes wird weiterhin dadurch erleichtert, dass im Bereich der Bedienebene B ein Druckschalter 11 angebracht ist, der beim Zusammenklappen der Baugruppen das Messgerät (z. B. den Verstärkerteil) automatisch abschaltet. Der Schalter kann so ausgeführt sein, dass er auch bei geöffnetem Gerät durch Drehen oder Schieben in Ausschaltstellung gebracht werden kann. Ebenso ist es möglich, den Schalter mit den Scharniergliedern zu koppeln, so dass er bei Unterschreiten einer bestimmten Winkelstellung abschaltet.

Anschlussbuchsen 12 zum Anschliessen von Messleitungen sind in der Verarbeitungsbaugruppe untergebracht und von der Seite (Fig. 3) zugänglich. Die Messleitungen müssen somit beim Zusammenklappen des Gerätes nicht entfernt werden. Die Anschlussbuchsen 12 können aber auch im Bereich der Bedienebene B Platz finden. In diesem Fall ist es allerdings vorteilhaft, wenn bei ganz oder teilweise zusammengeklapptem Messgerät die Anzeigebaugruppe 1 die Bedienebene B nur soweit überdeckt, dass die Buchsen dann noch zugänglich bleiben.

**Patentansprüche**

1. Tragbares Vielfachmessgerät, bei dem sowohl die zur Sichtbarmachung des Messwertes einer zu untersuchenden Messgrösse dienende Anzeigebaugruppe (1) wie auch die die Messgrösse umformende bzw. anpassende Verarbeitungsbaugruppe (2) ein eigenes Gehäuse (1a, 2a) besitzt und beide Gehäuse (1a, 2a) so miteinander verbunden sind, dass sie im Ruhezustand zusammenklappbar sind, wobei zu schützende Bedien- und Anzeigeteile nach innen zu liegen kommen, dadurch gekennzeichnet, dass die Gehäuse (1a, 2a) im Bereich der Kante, um welche beim Zusammenklappen eine Schwenkung erfolgt, einen den nutzbaren Innenraum der Gehäuse (1a, 2a) erweiternden, vorzugsweise zylindrischen Wulst (1b, 2b, 2c) besitzen, der gleichzeitig als Scharnier ausgebildet ist, derart, dass zu jedem Gehäuse (1a, 2a) mindestens ein Scharnierglied (1b, 2b) gehört und die Gehäuse (1a, 2a) durch die den Wulst bildenden, ineinandergreifenden Scharnierglieder (1b, 2b, 2c) drehbar verbunden sind.

2. Tragbares Vielfachmessgerät nach Anspruch 1, dadurch gekennzeichnet, dass die Gehäuse abgesehen vom Wulst (1b, 2b, 2c) eine im wesentlichen quaderförmige Grundform besitzen und der Wulst mit den aussenliegenden Gehäuseflächen, der Standfläche (S) und der Deckfläche (D), in einer Ebene abschliesst.

3. Tragbares Vielfachmessgerät nach einem oder mehreren der vorhergehenden Ansprüche, dadurch gekennzeichnet, dass der Wulst (1b, 2b, 2c) über die Ebene mindestens einer der innen liegenden Flächen, d. h. über die Bedienfläche (B) bzw. die Anzeigefläche (A), hinausragt und der Aussendurchmesser (d) des Wulstes (1b, 2b, 2c) etwa der Gesamthöhe (h) der beiden zusammengeklappten Gehäuse (1a, 2a) entspricht.

4. Tragbares Vielfachmessgerät nach einem oder mehreren der vorhergehenden Ansprüche, dadurch gekennzeichnet, dass der zylindrische Wulst (1b, 2b, 2c) als dreigliedriges Scharnier ausgeführt ist und bei dem mittleren Scharnierglied (1b), das zum Gehäuse (1a) der Anzeigebaugruppe (1) gehört, beiseitig Lagerringe (1d, 1e) abgesetzt sind, die von den beiden äusseren Scharniergliedern (2b, 2c), die zum Gehäuse (2a) der Verarbeitungsbaugruppe (2) gehören, überlappt sind.

5. Tragbares Vielfachmessgerät nach einem oder mehreren der vorhergehenden Ansprüche, dadurch gekennzeichnet, dass sich der zylindrische Wulst (2b, 2c) mit weniger als der Hälfte seines Aussendurchmesser (d) über die Bedienfläche (B) erhebt und das Gehäuse (2a) der Verarbeitungsgruppe (2) aus zwei Gehäuseschalen $(2a_1, 2b_1; 2a_2, 2b_2)$ zusammengesetzt ist, wobei die zwischen ihnen liegende Trennfläche parallel zur Bedienfläche (B) verläuft und die zum Gehäuse (2a) der Verarbeitungsbaugruppe (2) gehörigen Teile des zylindrischen Wulstes (2b) halbiert.

6. Tragbares Vielfachmessgerät nach einem oder mehreren der vorhergehenden Ansprüche, dadurch gekennzeichnet, dass die Anzeigefläche (A) im zusammengeklappten Zustand des Messgerätes plan auf der Bedienfläche (B), nur durch ein flaches Pufferelement (10) getrennt, aufliegt und Bedienelemente wie der Knopf (5a) des Messbereichswahlschalters (5) in Vertiefungen der Bedienfläche (B) liegen.

7. Tragbares Vielfachmessgerät nach einem oder mehreren der vorhergehenden Ansprüche, dadurch gekennzeichnet, dass die ineinander gelagerten Scharnierglieder (1b, 2b, 2c) des zylindrischen Wulstes eine Drehschwenkung bis zu max. 180° erlauben und aufeinander eine solche Friktion ausüben bzw. so mit Rastnasen versehen sind, dass beide Gehäuseteile (1a, 2a) jede Winkelstellung entgegen der Schwerkraft beibehalten.

8. Tragbares Vielfachmessgerät nach einem oder mehreren der vorhergehenden Ansprüche, dadurch gekennzeichnet, dass das mittlere Scharnierglied (1b) des zylindrischen Wulstes (1b, 2b, 2c) derart gegenüber der Mitte versetzt ist, dass die beiden äusseren Scharnierglieder (2b, 2c) unterschiedlich lang sind und damit ein unterschiedliches Fassungsvermögen haben.

9. Tragbares Vielfachmessgerät nach einem oder mehreren der vorhergehenden Ansprüche, dadurch gekennzeichnet, dass der Innenraum mindestens eines der beiden äusseren Scharnierglieder (2b, 2c) zur Aufnahme handelsüblicher Batterien (6) ausgerüstet ist und durch einen abnehmbaren Deckel (9) nach aussen verschlossen ist.

10. Tragbares Vielfachmessgerät nach einem oder mehreren der vorhergehenden Ansprüche, dadurch gekennzeichnet, dass der Innenraum des zur Anzeigebaugruppe (1) gehörigen Scharniergliedes (1b) zur Aufnahme eines Messwerktubus (3a) eines elektromechanischen Messwerkes (3) dient, das einschliesslich Skala (3c) und Messzeiger (3b) im Gehäuse (1a) der Anzeigebaugruppe (1) untergebracht ist, wobei das Messwerk (3) so aufgebaut ist, dass der grösste Teil des Messwerktubus (3a) die Ebene der Skalenvorderseite überragt.

11. Tragbares Vielfachmessgerät nach einem oder meheren der vorhergehenden Ansprüche, dadurch gekennzeichnet, dass auf der dem zylindrischen Wulst (2b) gegenüberliegenden Seite an beiden Ecken des zur Verarbeitungsbaugruppe (2) gehörigen Gehäuses (2a) Ausparungen (2g, 2h) mit je einem eingesetzten Stift (7, 8) vorgesehen sind, an denen ein Trageband zu befestigen ist.

12. Tragbares Vielfachmessgerät nach einem oder mehreren der vorhergehenden Ansprüche, dadurch gekennzeichnet, dass auf der Bedienebene (B) ein Druckschalter (11) angebracht ist, der beim Zusammenklappen der beiden Gehäuse (1a, 2a) vom Anzeigeteil (1) erfasst wird und dadurch das Messgerät abschaltet und durch Drehen oder Schieben des Druckschalters (11) dieser in eine Raststellung zu bringen ist, in der er auch bei aufgeklapptem Gehäuse abschaltet.

13. Tragbares Vielfachmessgerät nach einem oder mehreren der vorhergehenden Ansprüche, dadurch gekennzeichnet, dass die Anzeigebaugruppe (1) die Bedienfläche (B) im zusammengeklappten Zustand des Messgerätes nur zum Teil abdeckt und einzelne auf der Bedienfläche (B) angeordnete Bedienelemente, wie Anschlussbuchsen (12), auch beim teilweise oder ganz zusammengeklappten Vielfachmessgerät zugänglich bleiben.

**Claims**

1. A portable multimeter, in which both the indicator assembly (1) used to indicate optically the measurement value of a measured variable to be tested and the processing assembly (2) converting or adapting the measured variable have an individual casing (1a, 2a) and both casings (1a, 2a) are joined together in such a way that in the inoperative state they may be folded together, wherein control and indicating elements to be protected are situated inside, characterized in that in the region of the edge about which pivoting takes place during folding, the casings, (1a, 2a) have a preferably cylindrical drum (1b, 2b, 2c) which increases the usable inner space of the casings (1a, 2a) and which is constructed at the same time as a hinge, such that at least one hinge member (1b, 2b) belongs to each casing (1a, 2a) and the casings (1a, 2a) are pivotally connected by the hinge members (1b, 2b, 2c) which form the drum and which engage in one another.

2. A portable multimeter according to Claim 1, characterized in that apart from the drum (1b, 2b, 2c) the casings have a substantially cuboid basic shape and the drum terminates in the same plane as the outer casing surfaces, the base surface (S) and the cover surface (D).

3. A portable multimeter according to one or both of the preceding Claims, characterized in that the drum (1b, 2b, 2c) projects beyond the plane of at least one of the inner surfaces, i. e. beyond the control surface (B) and/or the display surface (A), and the external diameter (d) of the drum (1b, 2b, 2c) corresponds approximately to the total height (h) of the two casings (1a, 2a) folded together.

4. A portable multimeter according to one or more of the preceding Claims, characterized in that the cylindrical drum (1b, 2b, 2c) is constructed as three-membered hinge, and ring bearings (1d, 1e), which are overlapped by the two outer hinge members (2b, 2c) which belong to the casing (2a) of the processing assembly (2), are formed on the central hinge member (1b) which belongs to the casing (1a) of the indicator assembly (1).

5. A portable multimeter according to one or more of the preceding Claims, characterized in that the cylindrical drum (2b, 2c) rises above the control surface (B) by less than half its external diameter (d), and the casing (2a) of the processing assembly (2) is made up of two casing shells ($2a_1$, $2b_1$; $2a_2$, $2b_2$), and the separation plane lying between them extends parallel to the control surface (B) and halves the parts of the cylindrical drum (2b) belonging to the casing (2a) of the processing assembly (2).

6. A portable multimeter according to one or more of the preceding Claims, characterized in that in the folded state of the measurement instrument the dispaly surface (A) lies flat on the control surface (B), only separated by a flat cushioning element (10), and control elements such as the button (5a) of the range selection switch (5) are disposed in recesses in the control surface (B).

7. A portable multimeter according to one or more of the preceding Claims, characterized in that the engaging hinge members (1b, 2b, 2c) of the cylindrical drum allow rotation up to a maximum of 180° and cause friction upon one another or are provided with detents such that the two casing parts (1a, 2a) retain an angular position against the force of gravity.

8. A portable multimeter according to one or more of the preceding Claims, characterized in that the central hinge member (1b) of the cylindrical drum (1b, 2b, 2c) is offset with respect to the centre in such a way that the two outer hinge members (2b, 2c) are of different lengths and therefore have differing capacities.

9. A portable multimeter according to one or more of the preceding Claims, characterized in that the inner space of at least one of the two outer hinge members (2b, 2c) is fitted to receive batteries (6) standard in the trade and is closed by a removable lid (9) towards the outside.

10. A portable multimeter according to one or more of the preceding Claims, characterized in that the inner space of the hinge member (1b) belonging to the indicator assembly (1) is used to receive a measurement tube (3a) of an electro-mechanical measuring means (3), which is disposed in the casing (1a) of the indicator assembly (1) together with the dial (3c) and the measurement pointer (3b), the measuring means (3) being constructed such that the greater part of the measurement tube (3a) projects beyond the front side of the dial.

11. A portable multimeter according to one or more of the preceding Claims, characterized in that on both corners of the casing (2a) belonging to the processing assembly (2), on the side facing the cylindrical drum (2b), recesses (2g, 2h) are provided, each having a pin (7, 8) inserted, to which a carrying strap may be attached.

12. A portable multimeter according to one or more of the preceding Claims, characterized in that a press switch (11), which is actuated by the indicator part (1) when the two casings (1a, 2a) are folded together and in this way switches off the measurement instrument, is disposed on the control surface (B), and by turning or pushing the press switch (11) the latter may be set in an inoperative position in which it also switches off when the casing is open.

13. A portable multimeter according to one or more of the preceding Claims, characterized in that the indicator assembly (1) only partially covers the control surface (B) when the measurement instrument is folded up, and individual control elements, such as sockets (12), disposed on the control surface (B) also remain accessible when the multimeter is partially or completely folded up.

**Revendications**

1. Appareil de mesures multiples portable dans lequel tant l'ensemble d'affichage (1) servant à rendre visible la valeur de mesure d'une grandeur mesurée à contrôler que l'ensemble de traitement (2) trasformant où adaptant la grandeur mesurée possèdent un boîtier particulier (1a, 2a) et où les deux boîtiers (1a, 2a) sont reliés de telle façon l'un à l'autre qu'ils peuvent se replier à l'état de repos, les parties de service et d'affichage à protéger venant alors se situer vers l'intérieur, caractérisé en ce que les boîtiers (1a, 2a) comportent, dans la zone de l'arête autour de laquelle a lieu un pivotement lors du repliement, un renflement (1b, 2b, 2c) de préférence cylindrique, élargissant l'espace interne utilisable des boîtiers (1a, 2a) et qui en même temps est conformé comme une charnière de telle manière qu'à chaque boîtier (1a, 2a), appartient au moins un élément de charnière (1b, 2b) et que les boîtiers sont connectés de manière à pouvoir tourner par les éléments de charnière (1b, 2b, 2c) s'emboîtant les uns dans les autres et formant le renflement.

2. Appareil de mesures multiples portable selon la revendication 1, caractérisé en ce que les boîtiers, en plus du renflement (1b, 2b, 2c), comportent une forme de base essentiellement parallélépipédique et que le renflement se ferme en un plan avec les faces de boîtier externes, la face support (S) et la face couvercle (D).

3. Appareil de mesures multiples portable selon l'une ou plusieurs des revendications précédentes, caractérisé en ce que le renflement (1b, 2b, 2c) dépasse au-dessus du plan d'au moins une des faces se trouvant à l'intérieur, c'est-à-dire au-dessus de la surface de service (B) ou de la surface d'affichage (A) et que le diamètre externe (d) du renflement (1b, 2b, 2c) correspond à peu près à la hauteur totale (h) des deux boîtiers repliés (1a, 2a).

4. Appareil de mesures multiples portable selon l'une ou plusieurs des revendications précédentes, caracérisé en ce que le renflement cylindrique (1b, 2b, 2c) est conformé comme une charnière à trois éléments et que, dans l'élément de charnière moyen (1b) qui appartient au boîtier (1a) de l'ensemble d'affichage (1), des deux côtés des bagues de portée (1d, 1e) sont en décrochement, ces bagues étant chevauchées par les deux éléments externes de charnière (2b, 2c) appartenant au boîtier (2a) de l'ensemble de traitement (2).

5. Appareil de mesures multiples portable selon l'une ou plusieurs des revendications précédentes, caractérisé en ce que le renflement cylindrique (2b, 2c) se soulève au-dessus de la surface de service (D) avec moins de la moitié de son diamètre externe (d) et que le boîtier (2a) de l'ensemble de traitement (2) est composé de deux coquilles de boîtier (2a₁, 2b₁; 2a₂, 2b₂), la face de séparation située entre elles s'étendant parallèlement à la face de service (B) et partageant en deux les parties du renflement cylindrique (2b) appartenant au boîtier (2a) de l'ensemble de traitement (2).

6. Appareil de mesures multiples portable selon l'une ou plusieurs des revendications précédentes, caractérisé en ce que la face d'affichage (A) repose dans la position repliée de l'appareil de mesure de façon plane sur la face de service (B), séparée seulement par un élément tampon plat (10) et que des éléments de service tels que le bouton (5a) du commutateur de sélection des gammes de mesures (5) se trouvent dans des renfoncements de la face de service (B).

7. Appareil de mesures multiples portable selon l'une ou plusieurs des revendications précédentes, caractérisé en ce que les éléments de charnière (1b, 2b, 2c) du renflement cylindrique emboîtés les uns dans les autres permettent un pivotement rotatif de jusqu'au maximum 180° et exercent l'un sur l'autre une telle friction ou bien sont munis de languettes d'arrêt de manière que les deux parties de boîtier (1a, 2a) conservent chaque position angulaire à l'encontre de la gravité.

8. Appareil de mesures multiples portable selon l'une ou plusieurs des revendications précédentes, caractérisé en ce que l'élément central de charnière (1b) du renflement cylindrique (1b, 2b, 2c) est décalé de telle manière par rapport au milieu que les deux éléments externes de charnière (2b, 2c) sont différemment longs et ainsi ont une capacité de préhension différente.

9. Appareil de mesures multiples portable selon l'une ou plusieurs des revendications précédentes, caractérisé en ce que l'espace interne d'au moins un des deux éléments externes de charnière (2b, 2c) est équipé pour recevoir des batteries de type commercial (6) et est fermé à l'extérieur par un couvercle amovible (9).

10. Appareil de mesures multiples portable selon l'une ou plusieurs des revendications précédentes, caractérisé en ce que l'espace interne de l'élément de charnière (1b) appartenant à l'ensemble de l'affichage (1) sert à recevoir un tube de mécanisme de mesure (3a) d'un mécanisme de mesure (3) électromécanique qui est disposé, y compris une échelle (3c) et un indicateur de mesure (3b), dans le boîtier (1a) de l'ensemble d'affichage (1), le mécanisme de mesure (3) étant monté de telle manière que la plus grande partie du tube (3a) du mécanisme dépasse du plan du côté avant de l'échelle.

11. Appareil de mesures multiples portable selon l'une ou plusieurs des revendications précédentes, caractérisé en ce que du côté faisant face au renflement cylindrique (2b) aux deux coins du boîtier (2a) appartenant à l'ensemble de traitement (2) sont prévus des évidements (2g, 2h) dans lesquels est insérée une tige respective (7, 8) et auxquels est fixée une bande porteuse.

12. Appareil de mesures multiples portable selon l'une ou plusieurs des revendications précédentes, caractérisé en ce que sur le plan de service (B) se trouve un commutateur à pression (11) qui est saisi lors du repliement des deux boîtiers (1a, 2a) par la partie d'affichage (1) et ainsi met hors circuit l'appareil de mesure et en ce que par une rotation ou une poussée du commutateur à pression (11), celui-ci doit être mis dans une position d'arrêt dans laquelle il met hors service même lorsque le boîtier est déplié.

13. Appareil de mesures multiples portable selon l'une ou plusieurs des revendications précédentes, caractérisé en ce que l'ensemble d'affichage (1) recouvre la face de service (B) seulement en partie dans la position repliée de l'appareil de mesure et que des éléments séparés de service disposés sur la face de service (B) tels que des douilles de raccordement (12) restent accessibles même lorsque l'appareil de mesures multiples est partiellement ou entièrement replié.

Fig.6

Fig.7

Fig.1A

Fig.1B

Fig.2

Fig.3

Fig.4

Fig.5

0 016 210